# EUROPÄISCHE PATENTANMELDUNG

(11) **EP 3 131 073 A1**
(43) Veröffentlichungstag der Anmeldung: **15.02.2017**
(21) Anmeldenummer: 15180933.2
(22) Anmeldetag: 13.08.2015
(51) Int. Cl.: G08B 17/103, G08B 17/107, H01L 25/16, H01L 31/147, H05B 33/08

(54) **RAUCHDETEKTIONSEINHEIT MIT LEUCHTDIODE UND PHOTOEMPFÄNGER, UND MIT EINEM IN DER LEUCHTDIODE ANGEORDNETEN LED-CHIP UND PHOTOSENSOR ZUR BESTIMMUNG EINES ALTERUNGSGRADS UND/ODER EINES LICHTSTROMKOMPENSATIONSWERTS, SOWIE EINE LEUCHTDIODE**

(71) Anmelder: Siemens Schweiz AG, 8047 Zürich (CH)
(72) Erfinder: Aebersold, Hans, 8906 Bonstetten (CH)
(74) Vertreter: Maier, Daniel Oliver

(57) **Zusammenfassung**

Eine optische Rauchdetektionseinheit für einen Gefahrenmelder weist eine Leuchtdiode (L, DL) zum Aussenden von Licht auf, wobei die Leuchtdiode eine einstückige Baueinheit ist und ein LED-Gehäuse (7) mit zumindest einen darin angeordneten LED-Chip (R, B) und den LED-Chip kontaktierende, aus dem LED-Gehäuse herausgeführte Anschlusskontakte (1) umfasst. Die Rauchdetektionseinheit weist einen spektral auf ausgesandtes Licht empfindlichen Photoempfänger (2) für die Rauchdetektion sowie eine mit der Leuchtdiode und mit dem Photoempfänger verbundene Steuereinheit (MC) zur elektrischen Ansteuerung der Leuchtdiode sowie zur Bewertung eines vom Photoempfänger ausgegebenen Sensorsignals auf Brandkenngrössen hin auf. Erfindungsgemäss weist die Leuchtdiode einen spektral auf das ausgesandte Licht empfindlichen Photosensor (PD) auf. Die Steuereinheit ist dazu eingerichtet, während der elektrischen Ansteuerung der Leuchtdiode zugleich eine elektrische Kenngrösse des Photosensors zu erfassen. Sie ist dazu eingerichtet, um daraus eine Alterungsinformation der Leuchtdiode abzuleiten und auszugeben und/oder um daraus eine Abnahme des Lichtstroms der Leuchtdiode zu bestimmen und diese mittels geänderter elektrischer Ansteuerung der Leuchtdiode durch die Steuereinheit zu korrigieren. Schliesslich betrifft die Erfindung eine Leuchtdiode mit integrierter Photodiode.

## Beschreibung

Die Erfindung betrifft eine optische Rauchdetektionseinheit für einen Gefahrenmelder, insbesondere für einen Rauchmelder. Die Rauchdetektionseinheit weist zumindest eine Leuchtdiode zum Aussenden von Licht auf. Die Leuchtdiode ist eine einstückige Baueinheit und umfasst ein LED-Gehäuse mit einem darin angeordneten LED-Chip sowie den LED-Chip kontaktierende, aus dem LED-Gehäuse herausgeführte Anschlusskontakte. Die Rauchdetektionseinheit umfasst zudem einen zumindest spektral auf ausgesandtes Licht empfindlichen Photoempfänger für die Rauchdetektion, wie z.B. eine Photodiode, sowie eine mit der Leuchtdiode und mit dem Photoempfänger verbundene Steuereinheit. Die Steuereinheit ist typischerweise ein Mikrocontroller. Sie ist zumindest zur elektrischen Ansteuerung der Leuchtdiode (zum Leuchten) sowie zur Bewertung eines vom Photoempfänger ausgegebenen Sensorsignals auf Brandkenngrössen hin vorgesehen. Die jeweiligen Verarbeitungsschritte für die zeitliche Ansteuerung der beiden LED-Chips sowie die synchronisierte Erfassung und Auswertung des jeweiligen Photosensorsignals können durch geeignete, auf dem Mikrocontroller ausführbare Programmschritte realisiert sein. Die Leuchtdiode, der Photoempfänger sowie der Mikrocontroller sind vorzugsweise auf einem Schaltungsträger angeordnet und untereinander verschaltet.

Derartige Rauchdetektionseinheiten sind allgemein bekannt. Sie können - wie auch bei der vorliegenden Erfindung - Teil eines Streulichtrauchmelders in geschlossener oder offener Bauweise sein. In geschlossener Bauweise weist ein solcher Streulichtrauchmelder eine für zu detektierenden Rauch durchlässige, jedoch gegen direktes Umgebungslicht abgeschirmte optische Messkammer auf. Eine derartige Messkammer wird oft auch als Labyrinth bezeichnet. Streulichtrauchmelder der offenen Bauart weisen dagegen einen ausserhalb des Meldergehäuses im Freien liegenden Detektionsraum auf. Schliesslich können derartige Rauchdetektionseinheiten Teil eines Extinktionsrauchmelders sein, bei dem die Lichtschwächung durch anwesenden Rauch durch den Photoempfänger detektiert und auswertet wird.

Bekannt ist auch, dass Leuchtdioden im Betrieb altern und im Laufe der Zeit eine verringerte Lichtleistung aufweisen. Im Gegensatz dazu zeigen Photosensoren, wie z.B. Photodioden, vergleichsweise kleine, vernachlässigbare Alterungserscheinungen. Es ist folglich die Lichtleistung zu überwachen, um im Fall einer zu geringen Lichtleistung für die Rauchdetektion eine Warnmeldung auszugeben. Alternativ kann die Ansteuerleistung oder die Pulsdauer für die Ansteuerung der Leuchtdiode erhöht werden, um die verringerte Lichtleistung bzw. den verringerten emittierten Lichtstrom zu korrigieren. Hierzu ist die Verwendung eines separaten Photosensors bekannt, der vorzugsweise direktes Licht von der Leuchtdiode empfängt und der Leuchtdiode gegenüberliegend angeordnet ist. Abhängig vom Photoempfängersignal erfolgt dann die Ausgabe der Warnmeldung und/oder es erfolgt eine Lichtleistungskompensation über dem Weg der elektrischen Ansteuerung der Leuchtdiode.

Weiterhin ist bekannt, dass sämtliche optoelektronischen Bauelemente in der Rauchdetektionseinheit mit der Zeit verschmutzen. Das bedeutet, dass die optische Sendeleistung der Leuchtdiode und die optische Detektionsempfindlichkeit des Photoempfängers für die Rauchdetektion sowie des separaten Photoempfängers für die Lichtleistungs- bzw. Lichtstromüberwachung mit zunehmender Verschmutzung und unabhängig von der Alterung dieser optoelektronischen Bauelemente abnehmen.

Schliesslich sind aus dem Stand der Technik Leuchtdioden, insbesondere ein-, zwei- oder mehrfarbige Leuchtdioden, bekannt, die einstückige Baueinheiten sind. Derartige Leuchtdiode weisen ein LED-Gehäuse, zumindest einen darin angeordneten LED-Chip für die jeweilige "Farbe" sowie den jeweilige LED-Chip kontaktierende, aus dem LED-Gehäuse herausgeführte Anschlusskontakte auf.

Davon ausgehend ist es eine Aufgabe der Erfindung, eine optische Rauchdetektionseinheit anzugeben, die über die Stand- und Betriebszeit hinweg zuverlässiger arbeitet.

Die Aufgabe wird mit den Merkmalen des Hauptanspruchs gelöst. Vorteilhafte Ausführungsformen der vorliegenden Erfindung sind in den abhängigen Ansprüchen angegeben. In den unabhängigen Ansprüchen 12 bis 14 sind ein geschlossener, ein offener und ein Extinktionsrauchmelder angegeben, die jeweils eine erfindungsgemässe Rauchdetektionseinheit aufweisen. Im Anspruch 15 ist eine Zwei- oder Mehrfarben-Leuchtdiode angegeben, die für eine erfindungsgemässe Rauchdetektionseinheit vorgesehen und geeignet ist.

Erfindungsgemäss weist die Leuchtdiode einen spektral auf das ausgesandte Licht empfindlichen Photosensor auf. Die Steuereinheit ist dazu eingerichtet, die Leuchtdiode elektrisch, insbesondere gepulst anzusteuern und zugleich eine elektrische Kenngrösse des Photosensors zu erfassen, um daraus eine Alterungsinformation der Leuchtdiode abzuleiten und auszugeben. Alternativ oder zusätzlich kann die Steuereinheit dazu eingerichtet sein, um aus der erfassten Kenngrösse des Photosensors die Abnahme des Lichtstroms der Leuchtdiode zu bestimmen und durch eine geänderte elektrische Ansteuerung der Leuchtdiode zu korrigieren bzw. zu kompensieren.

Die Steuereinheit ist somit dazu eingerichtet, vorzugsweise den durch den Photosensor fliessenden Photostrom als Mass für den emittierten Lichtstrom der angesteuerten Leuchtdiode zu erfassen. Sie ist ausserdem dazu eingerichtet, eine vom Grad der Abnahme des Photostroms abhängige Alterungsinformation der angesteuerten Leuchtdiode abzuleiten und auszugeben und/oder davon abhängig die elektrische Ansteuerung der angesteuerten Leuchtdiode zu verändern, um eine entsprechende Abnahme des emittierten Lichtstroms zu korrigieren.

Der Photosensor ist insbesondere im LED-Gehäuse aufgenommen. Insbesondere ist er optisch mit dem LED-Chip bzw. mit den LED-Chips gekoppelt. Dadurch gelangt ein Teil des vom LED-Chips bzw. von den LED-Chips ausgesandten Lichts mittelbar oder unmittelbar, wie z.B. durch Streuung oder Reflexion, zum Photosensor und ist dann durch diesen detektierbar.

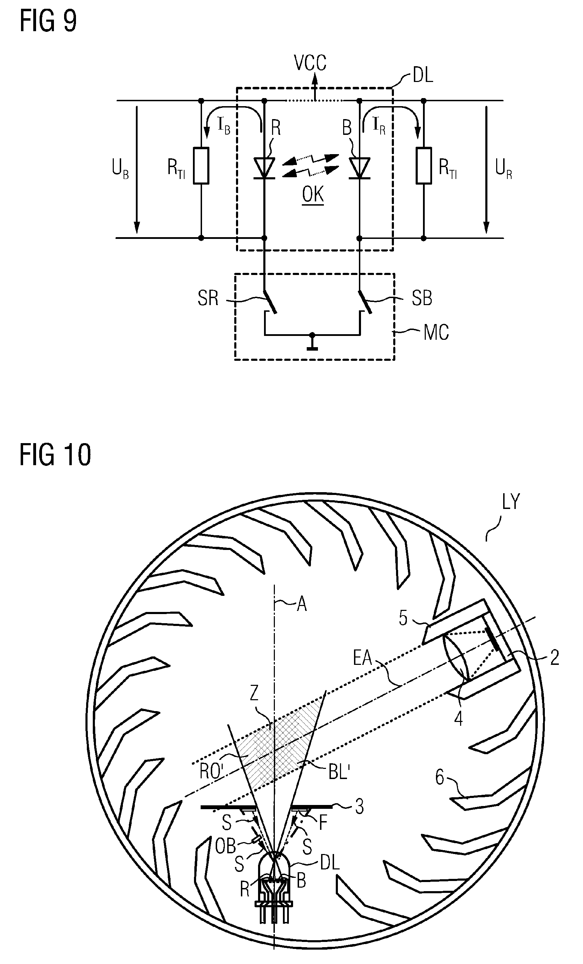

Anstelle des Photostroms kann auch eine von der Leuchtdiode erzeugte Photospannung als elektrische Kenngrösse erfasst werden. Hierzu wird parallel zur Leuchtdiode ein ohmscher Transimpedanzwiderstand geschaltet, der den durch die Leuchtdiode fliessenden Photostrom in eine dazu proportionale Photospannung umsetzt. Dabei wird die Leuchtdiode in ihrem Betrieb als Photodiode von dem Teil der dazu vorgesehenen Schaltungsanordnung (siehe FIG 9) freigeschaltet, der zur elektrischen Ansteuerung der Leuchtdiode zum Leuchten vorgesehen ist.

Der Grad der Abnahme des Photostroms kann durch Ermittlung der Differenz zwischen einem Nennstromwert für den Photostrom und einem aktuellen Ist-Stromwert des Photostroms erfolgen. Der Nennstromwert kann z.B. im Rahmen einer Typ- oder Serienprüfung der optischen Rauchdetektionseinheit ermittelt werden. Er kann auch ein Mittelwert von gemessenen Stromwerten am Anfang der Betriebszeit des Rauchmelders sein. Der so festgelegte Nennstromwert kann z.B. in einem Speicher der Steuereinheit, d.h. in einem nichtflüchtigen Speicher des Mikrocontrollers, hinterlegt werden. Die Steuereinheit kann dazu eingerichtet sein, wiederholt und insbesondere zyklisch einen aktuellen Ist-Stromwert des Photostroms zu erfassen und rechnerisch die Differenz aus dem hinterlegten Nennstromwert und dem aktuell erfassten Ist-Stromwert des Photostroms zu bilden. Diese Differenz aus den beiden Stromwerten entspricht dann dem Grad der Abnahme des Photostroms.

Die Alterungsinformation kann z.B. ein mehrstufiger Alterungsgrad sein oder eine binäre Alterungsinformation sein wie z.B. "nicht gealtert" oder "gealtert". Der Alterungsgrad kann z.B. durch einen Zahlen- oder Prozentwert, wie z.B. von 0% bis 100%, repräsentiert sein. Beispielsweise kann ein Prozentwert von 0 den Neuzustand und ein Prozentwert von 100 einen Zustand repräsentieren, bei dem eine sichere Rauchdetektion wegen zu geringem Streulicht nicht mehr möglich ist. Die Prozentwerte für den Neuzustand wie auch für den Zustand der nicht mehr sicheren Rauchdetektion können z.B. im Rahmen einer Typprüfung der Rauchdetektionseinheit bzw. des Rauchmelders messtechnisch ermittelt werden. Dazwischen liegende Prozentwerte können linear interpoliert sein. Bei einem vorgegebenen Wert, wie z.B. bei 50% oder 80%, ist dann eine entsprechende Warnmeldung ausgebbar, wie z.B. über einen angeschlossenen Melderbus des Rauchmelders, über Funk und/oder akustisch oder optisch am Rauchmelder selbst. Die Zuordnung zwischen erfasstem Photostrom des Photosensors zu dem beispielhaften Prozentbereich von 0% bis 100% kann mittels einer Zahlentabelle oder einer Kennlinie erfolgen, die zur späteren Alterungsbewertung durch den Mikrocontroller in einem elektronischen Speicher des Mikrocontrollers hinterlegt werden.

Die Steuereinheit kann dazu eingerichtet sein, den emittierten Lichtstrom der (zum Leuchten) angesteuerten Leuchtdiode mittels eines offenen oder geschlossenen Regelkreises an einen geforderten Nennlichtstrom für die Rauchdetektion nachzuführen. Der Lichtstrom kann z.B. durch eine Verlängerung der Pulslänge bei der elektrischen Ansteuerung der Leuchtdiode verändert werden, sodass auch die Lichtenergie pro Lichtpuls zunimmt. Alternativ oder zusätzlich kann auch der Ansteuerstrom und somit auch der Lichtstrom bzw. die Lichtleistung der Leuchtdiode erhöht werden. Im Sinne eines geschlossenen Regelkreises kann fortlaufend der aktuelle Lichtstrom ermittelt und durch Änderung in der elektrischen Ansteuerung der Leuchtdiode nachgeführt werden.

Der besondere Vorteil liegt darin, dass der LED-Chip und der Photosensor durch die Integration in einem gemeinsamen LED-Gehäuse keiner Verschmutzung unterliegen. Somit können durch die direkte optische Kopplung zwischen dem LED-Chip und dem Photosensor keine Verschmutzungspartikel in den optischen Kopplungspfad gelangen. Der Photoempfänger misst folglich über die Betriebszeit der Rauchdetektionseinheit immer den aktuellen Lichtstromwert bzw. die aktuelle Lichtleistung des LED-Chips. Hierzu reicht ein gewisses Streulicht vom LED-Chip, das unmittelbar oder über Reflektionen am LED-Gehäuse auf den Photosensor auftritt, zur möglichen messtechnischen Erfassung und Bewertung aus.

Durch die Integration in die einstückige Leuchtdiode ist kein externer Photosensor mehr erforderlich. Das vom Photosensor ausgegebene Sensorsignal kann z.B. über einen weiteren und aus dem LED-Gehäuse herausgeführten Anschlusskontakt messtechnisch erfasst werden. Der Photosensor kann bereits auch eine integrierte Messschaltung aufweisen und eingerichtet sein, den Versorgungsstrom des LED-Chips mit einem dem aktuell gemessenen Lichtstromwert entsprechenden Stromsignal zu modulieren. Dieses Signal kann dann durch eine Messschaltung ausserhalb der Leuchtdiode erfasst und ausgewertet werden. In diesem Fall ist ein weiterer Anschlusskontakt nicht erforderlich.

Nach einer Ausführungsform ist der Photosensor eine spektral auf das ausgesandte Licht des LED-Chips empfindliche Photodiode, insbesondere eine PIN-Photodiode.

Einer Ausführungsform zufolge weist die Leuchtdiode zwei vorzugsweise typgleiche LED-Chips auf, wie z.B. blauleuchtende oder infrarotleuchtende LED-Chips. Es ist (nur) ein erster der beiden LED-Chips zum Aussenden von einfarbigem Licht vorgesehen, während (nur) der andere zweite LED-Chip zum Betrieb als Photosensor vorgesehen ist. Die Steuereinheit ist dazu eingerichtet, (nur) den ersten LED-Chip elektrisch (zum Leuchten) anzusteuern und zugleich den durch den zweiten LED-Chip fliessenden Photostrom oder eine durch den zweiten LED-Chip erzeugte Photospannung zu erfassen, um daraus die Alterungsinformation des ersten LED-Chips abzuleiten und auszugeben. Die Steuereinheit kann alternativ oder zusätzlich dazu eingerichtet sein, daraus die Abnahme des Lichtstroms des ersten LED-Chips zu bestimmen und durch eine geänderte elektrische Ansteuerung des ersten LED-Chips zu korrigieren.

Der Erfindung liegt die Erkenntnis zugrunde, dass jede Leuchtdiode auch als Photodiode verwendet bzw. betrieben werden kann, wenn auch mit einem erheblich schlechteren Wirkungsgrad im Vergleich zu Photodioden, die speziell zu Detektionszwecken entwickelt worden sind. Dennoch reicht das durch den jeweils anderen LED-Chip empfangene reflektierte Licht zumeist aus, um zumindest qualitativ den Lichtstrom des elektrisch angesteuerten LED-Chips zu bestimmen.

Der Vorteil bei dieser Ausführungsform liegt in der einfachen Realisierung einer überwachten einfarbigen Leuchtdiode, indem zwei baugleiche LED-Chips im Rahmen der Herstellung nebeneinander auf einem gemeinsamen LED-Chipträger appliziert und dann mit den Anschlusskontakten kontaktiert werden.

Nach einer dazu alternativen Ausführungsform ist die Leuchtdiode (zumindest) eine Zweifarben-Leuchtdiode. Sie kann alternativ auch eine Mehrfarben-Leuchtdiode sein, wie z.B. eine RGB-Leuchtdiode sein. Die hier bevorzugt betrachtete Zweifarben-Leuchtdiode weist einen ersten und zweiten LED-Chip zum Aussenden von Licht in einem ersten und in einem davon verschiedenen zweiten Wellenlängenbereich auf. Der erste LED-Chip kann z.B. zum Aussenden von Licht mit einer Wellenlänge im Bereich von 665 nm bis 1000 nm, insbesondere zum Aussenden von Licht mit einer Wellenlänge von 940 nm ± 40 nm oder von 860 nm ± 40 nm ausgebildet sein. Der zweite LED-Chip kann z.B. zum Aussenden von Licht mit einer Wellenlänge im Bereich von 350 nm bis 500 nm, insbesondere zum Aussenden von Licht mit einer Wellenlänge von 460 nm ± 40 nm oder 390 nm ± 40 nm ausgebildet sein. In Summe emittiert der erste LED-Chip vorzugsweise Licht im rot/orangen, roten oder infraroten Bereich und der zweite LED-Chip Licht im blaugrünen, blauen, violetten oder ultravioletten Bereich.

Die LED-Chips sind vorzugsweise als Flächenstrahler ausgebildet. Mit "Flächenstrahler" ist hier gemeint, dass das Licht aus einer ebenen Fläche mit einer Lambert'schen Lichtverteilung abgestrahlt wird. Die Flächenstrahler können somit auch als Lambert-Strahler bezeichnet werden.

Die Steuereinheit ist in diesem Fall dazu eingerichtet, einen der LED-Chips elektrisch (zum Leuchten) anzusteuern und den anderen LED-Chip in eine Betriebsart als Photodiode zu schalten. Dies kann auch alternierend für beide LED-Chips erfolgen. Die Steuereinheit ist zudem dazu eingerichtet, den durch den anderen LED-Chip fliessenden Photostrom oder eine durch den anderen LED-Chip erzeugte Photospannung als elektrische Kenngrösse zu erfassen, um daraus die Alterungsinformation des jeweiligen angesteuerten LED-Chips abzuleiten und auszugeben. Die Steuereinheit kann alternativ oder zusätzlich dazu eingerichtet sein, daraus die Abnahme des Lichtstroms des jeweiligen angesteuerten LED-Chips zu bestimmen und durch eine geänderte elektrische Ansteuerung des jeweiligen angesteuerten LED-Chips zu korrigieren.

Durch die Verwendung zweier "LED-Farben" ist eine verbesserte Rauchdetektion durch eine möglich Bestimmung der Teilchengrösse der Rauchteilchen und somit des Rauchtyps möglich. Zugleich ist vorteilhaft eine gegenseitige Überwachung der LED-Chips auf eine unzulässig hohe Alterung hin möglich.

Wie auch im vorgenannten Fall wirkt der jeweils nicht elektrisch angesteuerte LED-Chip als Photodiode. Dabei ist die Photoempfindlichkeit eines LED-Chips für empfangenes Licht umso besser, je kurzwelliger dieses gegenüber der Wellenlänge des Lichts ist, welches der LED-Chip bei elektrischer Ansteuerung aussendet. Mit anderen Worten detektiert ein Infrarot-LED-Chip in der Betriebsart als Photodiode blaues Licht deutlich besser als ein blauer LED-Chip infrarotes Licht.

Bei den beiden zuvor genannten beispielhaften Ausführungsformen sind die zwei LED-Chips nebeneinander auf einem Chipträger der Leuchtdiode angeordnet, wobei eine Kante eines LED-Chips einer Kante des anderen LED-Chips gegenüberliegt, sodass seitlich ausgesendetes Kantenlicht eines LED-Chips optisch seitlich in den anderen LED-Chip einkoppelt.

Die LED-Chips stammen üblicherweise aus einem Wafer mit einer Vielzahl in einem optoelektronischen Halbleiterprozess hergestellter LED-Chips. Ein solcher Wafer wird durch mechanische Trennprozesse, insbesondere durch Sägen oder Brechen, in die Vielzahl der LED-Chips zerlegt. Ein solches "nacktes" und für sich vollständig funktionsfähiges Bauteil wird auch als "Die" bezeichnet. Es weist daher eine typischerweise quadratische oder auch rechteckige Form auf. Ein dabei kaum verwertbarer Lichtanteil wird auch über die seitlichen Kanten eines derartigen LED-Chips ausgesandt. Genau dieser Anteil kann nun vorteilhaft zu Alterungsüberwachung verwendet werden.

Nach einer vorteilhaften Ausführungsform ist die Leuchtdiode eine Zweifarben-Leuchtdiode. Sie weist wiederum wie eingangs beschrieben einen ersten und zweiten LED-Chip zum Aussenden von Licht in einem ersten und in einem davon verschiedenen zweiten Wellenlängenbereich auf. Der Photosensor ist eine spektral auf das ausgesendete Licht empfindliche Photodiode, insbesondere eine PIN-Photodiode. Die Steuereinheit ist dazu eingerichtet ist, wahlweise einen der LED-Chips elektrisch (zum Leuchten) anzusteuern und zugleich den durch die Photodiode fliessenden Photostrom oder eine durch die Photodiode erzeugte Photospannung als elektrische Kenngrösse zu erfassen, um daraus die Alterungsinformation des jeweiligen angesteuerten LED-Chips abzuleiten und auszugeben. Alternativ oder zusätzlich ist die Steuereinheit dazu eingerichtet, daraus die Abnahme des Lichtstroms des jeweiligen angesteuerten LED-Chips zu bestimmen und diese durch eine geänderte elektrische Ansteuerung des jeweiligen angesteuerten LED-Chips zu korrigieren.

Durch die Verwendung einer spektral auf das ausgesandte Licht der beiden LED-Chips sensitiven Photodiode ist vorteilhaft eine sehr genaue Ermittlung des Alterungsgrads der beiden LED-Chips sowie deren Korrektur bzw. Kompensation möglich.

Ein weiterer Vorteil liegt in der kompakten Integration der Photodiode auf dem Chipträger zusammen mit den beiden benachbart angeordneten LED-Chips. Durch das Fehlen jeglicher Verschmutzungsmöglichkeit ist eine exakte Bestimmung der Alterung beider LED-Chips möglich.

Einer weiteren Ausführungsform zufolge bildet das LED-Gehäuse an seiner Aussenseite eine derartige optische Grenzfläche zur Umgebungsluft aus, dass ein Teil des von einem LED-Chip ausgesandten Lichts zum Photosensor respektive zum anderen LED-Chip reflektiert wird. Der Photosensor ist vorzugsweise eine Photodiode. Das LED-Gehäuse ist aus einem transparenten, vorzugweise aus einem klaren Werkstoff hergestellt, wie z.B. aus einem Kunststoff oder Glas. Mit "transparent" ist hier gemeint, dass das Kunststoff- oder Glasgehäuse zumindest für das vom ersten und zweiten LED-Chip stammende emittierte Licht durchlässig ist. Dabei werden vom LED-Chip bzw. von den LED-Chips ausgesandte Lichtstrahlen für bestimmte Winkelbereiche bei Vorliegen des Grenzwinkels für die Totalreflexion an der Aussenseite des LED-Gehäuses reflektiert. Dieser Effekt zeigt sich auch bei Standardgehäusen von Leuchtdioden, die einen 3 mm- oder einen 5 mm-Durchmesser aufweisen. Diese Standardgehäuse werden in einem Kunststoffgussverfahren hergestellt, bei dem ein LED-Chipträger mit den darauf applizierten LED-Chips, mit dem Photosensor und mit den Anschlusskontakten in das Kunststoffgehäuse mit eingegossen werden. Derartige 3 mm- oder 5 mm-Leuchtdioden werden bekanntermassen "off the shelf" als massenhaftes Consumerprodukt verkauft. Leuchtdioden mit einem solchen Standardgehäuse sind typischerweise für die Durchlochmontage vorgesehen.

Das LED-Gehäuse kann alternativ oder zusätzlich derartige optische Eigenschaften und/oder optische Strukturen aufweisen, dass ein Teil des von einem LED-Chip ausgesandten Lichts zum Photosensor respektive zum anderen LED-Chip reflektiert wird. Der Photosensor ist vorzugsweise eine Photodiode. Dies kann z.B. durch Einbetten von reflektierenden Streukörpern im LED-Gehäuse erfolgen. Es kann auch ein Bereich auf der sonst glatten Aussenfläche des LED-Gehäuses aufgeraut sein, wie z.B. durch mechanische Bearbeitung oder durch Anätzen, so dass dieser Bereich wie ein Streukörper oder Reflektor wirkt.

Nach einer vorteilhaften Ausführungsform weist die Rauchdetektionseinheit eine der Leuchtdiode optisch nachgeschaltete Blende und/oder ein optisch nachgeschaltetes Rückstreuobjekt auf, sodass ein Teil des ausgesandten Lichts wieder in Richtung zur Leuchtdiode reflektiert wird, um damit den jeweiligen LED-Chip zu beleuchten. In diesem Fall befindet sich das Rückstreuobjekt ausserhalb der Leuchtdiode. Im einfachsten Fall kann ein Teil der Blendenfläche, welche der Leuchtdiode gegenüberliegt, reflektierend oder glänzend ausgebildet sein. Insbesondere ist diese Blendenfläche derart ausgerichtet, dass das dort auftreffende Licht der Leuchtdiode gezielt in Richtung Leuchtdiode zurückreflektiert wird.

Die Leuchtdiode kann alternativ auch ein SMD-Bauelement für die Oberflächenmontage auf einem Schaltungsträger sein.

Die Aufgabe der Erfindung wird weiterhin durch einen Streulichtrauchmelder gelöst, der ein Meldergehäuse und eine darin aufgenommene optische Messkammer mit zumindest einer Öffnung für den möglichen Durchtritt von zu detektierendem Rauch aufweist. In der Messkammer ist eine gegenüber Umgebungslicht abgeschirmte erfindungsgemässe Rauchdetektionseinheit aufgenommen. Der Photoempfänger ist mit zumindest einer Leuchtdiode in einer Vorwärts- und/oder Rückwärtsstreulichtanordnung angeordnet. Die Steuereinheit ist dazu eingerichtet, einen Brandalarm auszugeben, falls das vom Photoempfänger ausgegebene Sensorsignal einen Mindeststreulichtpegel überschreitet. Bei einer Vorwärtsstreulichtanordnung liegt der Winkel zwischen Leuchtdiode und dem Photoempfänger in einem Bereich von 20° bis 90°, insbesondere in einem Bereich von 30° bis 70°. Bei einer Rückwärtsstreulichtanordnung liegt dieser Winkel in einem Bereich von mehr als 90° bis 160°, insbesondere in einem Bereich von 110° bis 150°.

Weiterhin wird die Aufgabe durch einen offenen Streulichtrauchmelder mit einer erfindungsgemässen Rauchdetektionseinheit gelöst. Letztere ist in oder an einem Meldergehäuse des offenen Streulichtrauchmelders angeordnet, wobei sich ein für die Detektion von Streulicht vorgesehener Detektionsraum dann ausserhalb des Meldergehäuses befindet. Mit anderen Worten befinden sich zwischen der Leuchtdiode und dem im Freien liegenden Detektionsraum einerseits und zwischen dem Photoempfänger und dem im Freien liegenden Detektionsraum keine weiteren Teile des Meldergehäuses. Davon abgesehen kann eine transparente Abdeckung zum Schutz gegen Verschmutzung der Leuchtdiode und des Photoempfängers am Meldergehäuse vorhanden sein. Die Steuereinheit ist dazu eingerichtet, einen Brandalarm auszugeben, falls das vom Photoempfänger ausgegebene Sensorsignal einen Mindeststreulichtpegel überschreitet.

Die Aufgabe der Erfindung wird weiterhin durch einen Extinktionsrauchmelder gelöst, der ein Meldergehäuse mit zumindest einer Öffnung für den möglichen Durchtritt von zu detektierendem Rauch sowie eine im Meldergehäuse angeordnete, gegenüber Umgebungslicht abgeschirmte erfindungsgemässe Rauchdetektionseinheit aufweist. Der Photoempfänger ist der Leuchtdiode zur Detektion von direktem Licht gegenüberliegend angeordnet. Die Steuereinheit ist dazu eingerichtet, einen Brandalarm auszugeben, falls das vom Photoempfänger ausgegebene Sensorsignal einen Vergleichswert für eine maximal zulässige Lichtabschwächung unterschreitet.

Schliesslich wird die Aufgabe der Erfindung durch eine Leuchtdiode, insbesondere durch eine Mehrfarben-Leuchtdiode, gelöst, bei der erfindungsgemäss im LED-Gehäuse eine zumindest spektral auf das von den jeweiligen LED-Chips der Leuchtdiode ausgesandte Licht empfindliche Photodiode angeordnet ist, so dass zumindest ein Teil des ausgesandten Lichts durch die Photodiode detektierbar ist. Die Photodiode ist mit den herausgeführten oder mit zumindest einem weiteren Anschlusskontakt kontaktiert sowie bestimmungsgemäss zur Lichtdetektion und nicht zum Aussenden von Licht ausgebildet ist. Die Photodiode ist insbesondere eine PIN-Photodiode. Die Photodiode kann auch eine integrierte elektronische Messverstärkerschaltung aufweisen.

Die Erfindung sowie vorteilhafte Ausführungen der vorliegenden Erfindung werden am Beispiel der nachfolgenden Figuren erläutert. Dabei zeigen:
- FIG 1: eine beispielhafte Leuchtdiode für eine erfindungsgemässe Rauchdetektionseinheit mit einem ersten LED-Chip sowie mit einem zweiten LED-Chip oder mit einer Photodiode zur Detektion eines Teils des vom zweiten LED-Chips ausgesandten Lichts,
- FIG 2: eine erste Ausführungsform mit einem einzigen LED-Chip und mit einer Photodiode gemäss der Erfindung,
- FIG 3: eine zweite Ausführungsform mit zwei LED-Chips,
- FIG 4: die erfindungsgemässe wechselweise Ansteuerung zweier LED-Chips und messtechnische Auswertung in symbolischer Darstellung,
- FIG 5: eine weitere Ausführungsform mit zwei nebeneinander angeordneten LED-Chips zur Emission und Detektion von jeweils ausgesandtem Kantenlicht gemäss der Erfindung,
- FIG 6: eine weitere Ausführungsform mit zwei LED-Chips und einer Photodiode zur Detektion jeweils eines Teils des von den LED-Chips ausgesandten Lichts gemäss der Erfindung,
- FIG 7, FIG 8: ein Beispiel für die Lichtausbreitung und Reflexion in einem LED-Gehäuse von beispielhaft blauem und roten Licht sowie dessen Detektion durch den jeweils anderen LED-Chip gemäss der Erfindung,
- FIG 9: eine beispielhafte Schaltungsanordnung zur wechselweisen Ansteuerung sowie zur wechselweisen Auswertung zweier LED-Chips jeweils mittels eines Transimpedanzwandlers gemäss der Erfindung, und
- FIG 10: ein Beispiel für eine erfindungsgemässe Rauchdetektionseinheit für einen Streulichtrauchmelder mit einer Zweifarben-LED und mit einem Photoempfänger in einer Vorwärtsstreulichtanordnung.

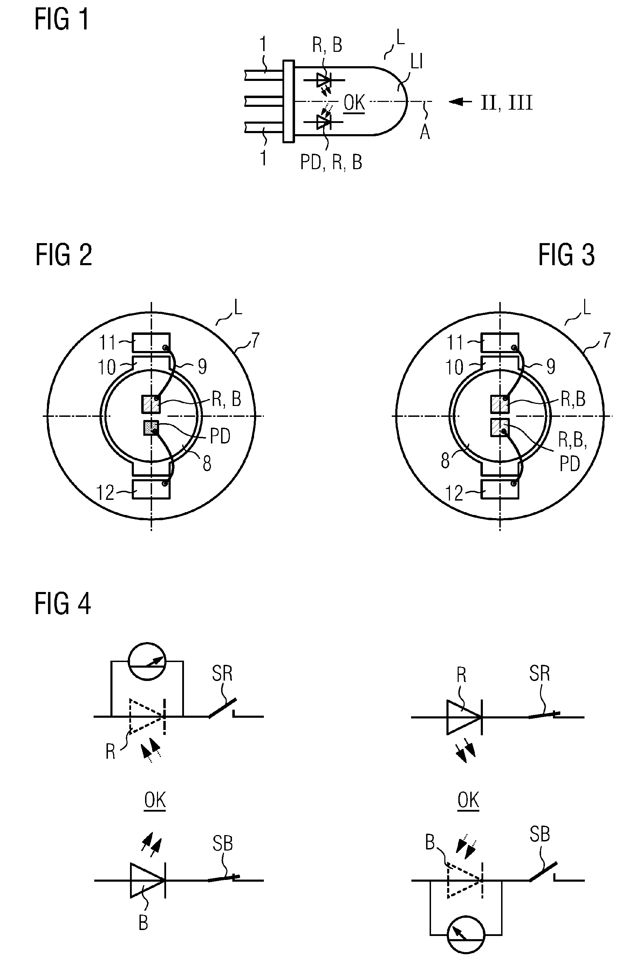

FIG 1 zeigt eine beispielhafte Leuchtdiode L für eine erfindungsgemässe Rauchdetektionseinheit mit einem ersten LED-Chip R, B sowie mit einem zweiten LED-Chip B, R oder alternativ mit einer Photodiode PD zur Detektion eines Teils des vom zweiten LED-Chips B, R ausgesandten Lichts. Das Bezugszeichen R deutet an, dass es sich vorzugsweise um einen rot- bzw. infrarotleuchtenden LED-Chip handelt, während das Bezugszeichen B andeutet, dass es sich vorzugsweise um einen blauleuchtenden LED-Chip handelt. Mit OK ist eine optische Kopplung bezeichnet. Diese steht symbolisch dafür, dass ein Teil des vom jeweiligen LED-Chip R, B, ausgesandten Lichts zum jeweils anderen LED-Chip B, R bzw. zur Photodiode PD gelangt, um dort detektiert werden zu können. Mit dem Bezugszeichen sind die Anschlusskontakte der Leuchtdiode L bezeichnet. Die gezeigte Leuchtdiode L weist weiter ein transparentes LED-Gehäuse auf, welches im Bereich der Lichtaustrittsseite eine optische Linse LI zur Fokussierung des ausgesandten Lichts ausbildet. Mit A ist die optische Achse bzw. die Hauptachse der Leuchtdiode L bezeichnet, entlang derer die Hauptausbreitung des ausgesandten Lichts erfolgt.

FIG 2 zeigt eine erste Ausführungsform mit einem einzigen LED-Chip R, B und mit einer Photodiode PD gemäss der Erfindung entlang der in FIG 1 gezeigten Blickrichtung II. Mit dem Bezugszeichen 7 sind ein LED-Gehäuse aus transparentem Kunststoff, mit 8 ein Chipträger und mit 9 Bonddrähte bezeichnet, die den LED-Chip R, B mit den aus dem LED-Gehäuse 7 geführten Anschlusskontakten 1 über entsprechende Kontaktierungsflächen 10, 11, 12 kontaktieren. Mit 10 ist eine gemeinsame Anschlusskontaktfläche für ein gemeinsames Spannungspotenzial bezeichnet und bildet nach aussen hin einen gemeinsamen Anschlusskontakt 1.

FIG 3 zeigt eine zweite Ausführungsform mit zwei LED-Chips R, B entlang der in FIG 1 gezeigten Blickrichtung III. Erfindungsgemäss handelt es sich bei den beiden LED-Chips R, B um typgleiche optoelektronische Bauelemente, die typischerweise aus einem gleichen Los stammen. Dabei ist bestimmungsgemäss ein erster der beiden LED-Chips R, B zum Aussenden von einfarbigem Licht vorgesehen, während der andere zweite LED-Chip R, B zum Betrieb als Photodiode vorgesehen. Hierzu ist eine mit den beiden LED-Chips R, B verbundene Steuereinheit dazu eingerichtet, (nur) den ersten LED-Chip R, B elektrisch anzusteuern und zugleich den durch den zweiten LED-Chip R, B fliessenden Photostrom oder eine durch den zweiten LED-Chip R, B erzeugte Photospannung zu erfassen, um daraus die Alterungsinformation des ersten LED-Chips R, B abzuleiten und auszugeben. Alternativ oder zusätzlich ist die Steuereinheit dazu eingerichtet, um daraus die Abnahme des Lichtstroms des ersten LED-Chips R, B zu bestimmen und diese durch eine geänderte elektrische Ansteuerung des ersten LED-Chips R, B zu korrigieren. Eine dazu geeignete Schaltungsanordnung ist im Beispiel der FIG 9 gezeigt.

FIG 4 zeigt die erfindungsgemässe wechselweise Ansteuerung zweier LED-Chips R, B der Leuchtdiode sowie die messtechnische Auswertung in symbolischer Darstellung. Im linken Teil der Figur ist der "blaue" LED-Chip B, symbolisiert durch einen geschlossenen Schalter SB, zum Aussenden von blauem Licht elektrisch angesteuert, während der "rote" LED-Chip R, symbolisiert durch einen geöffneten Schalter SR und durch ein Messgerät zu Erfassung einer elektrischen Kenngrösse des "roten" LED-Chips R, in einen Betrieb als Photodiode geschaltet ist und durch die optische Kopplung OK einen Teil des blauen Lichts detektiert. Im rechten Teil der Figur ist nun der "rote" LED-Chip R zum Aussenden von rotem Licht elektrisch angesteuert, während der "blaue" LED-Chip B in einen Betrieb als Photodiode geschaltet ist und durch die optische Kopplung OK einen Teil des roten Lichts detektiert. Dabei ist die Detektion von blauem Licht durch den "roten" LED-Chip R effizienter als die Detektion von rotem Licht durch den blauen LED-Chip B. Dies ist in der FIG 4 durch den kleineren Zeigerausschlag beim blauen LED-Chip B im Vergleich zum Zeigerausschlag beim roten LED-Chip R symbolisiert.

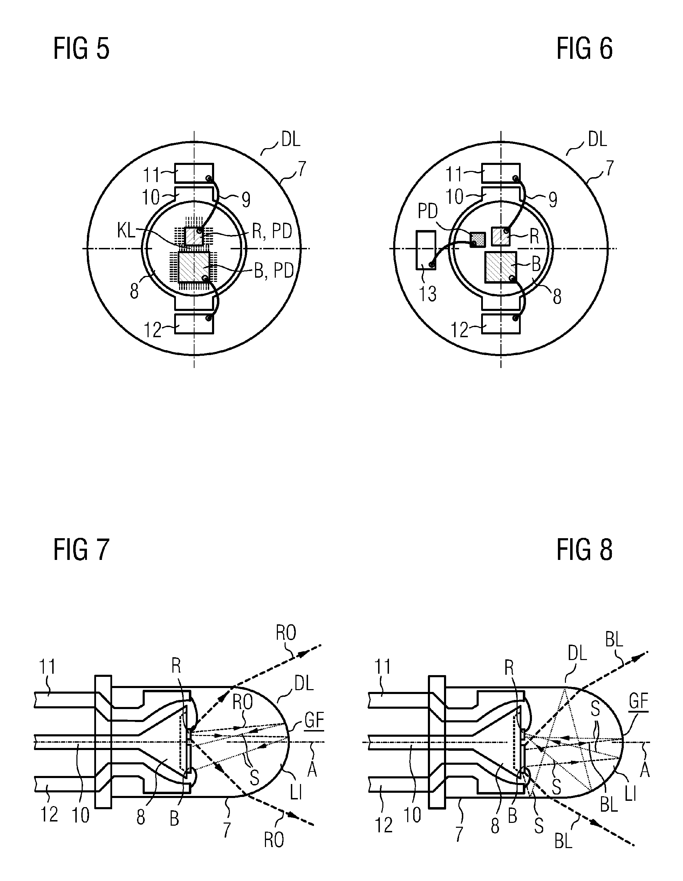

FIG 5 zeigt eine weitere Ausführungsform mit zwei nebeneinander angeordneten LED-Chips R, B zur Emission und Detektion von jeweils ausgesandtem Kantenlicht KL gemäss der Erfindung. Wie die FIG 5 zeigt, liegen sich zwei Kanten der beiden LED-Chips R, B gegenüber, so dass jeweils ausgesandtes Kantenlicht KL direkt seitlich beim jeweils gegenüberliegenden LED-Chip R, B einkoppeln kann. Bei der gezeigten Ausführungsform weist der "blaue" LED-Chip B im Vergleich zum "roten" LED-Chip R eine grössere optisch aktive Oberfläche von mehr als den Faktor 2,5 auf. Mit "optisch aktiv" sind die Teile der Oberfläche der LED-Chips gemeint, die bei Stromerregung Licht emittieren. Bereiche für die Kontaktierung der LED-Chips auf der Oberfläche, die z.B. zur Kontaktierung eines Bonddrahts bestimmt sind, gehören somit nicht dazu. Durch die grössere optisch aktive Oberfläche des "blauen" LED-Chips B lässt sich der schlechtere elektrooptische Wirkungsgrad bei der Lichterzeugung zumindest teilweise kompensieren.

FIG 6 zeigt eine weitere Ausführungsform mit zwei LED-Chips R, B und einer Photodiode PD zur Detektion jeweils eines Teils des von den LED-Chips R, B ausgesandten Lichts gemäss der Erfindung. Die Leuchtdiode ist somit eine Zweifarben-Leuchtdiode L. Die Photodiode PD ist spektral auf das ausgesendete zweifarbige Licht empfindlich. Die Photodiode PD ist eine PIN-Photodiode, wie z.B. eine Silizium-PIN-Photodiode, und vorzugsweise eine Silizium-PIN-Photodiode mit verbesserter Blauempfindlichkeit. Beide LED-Chips R, B und die als Chip ausgebildete bzw. als "Die" vorliegende Photodiode PD sind nebeneinander auf dem Chipträger 8 angeordnet.

Die Figuren 7 und 8 zeigen ein Beispiel für die Lichtausbreitung und Reflexion in einem LED-Gehäuse 7 von beispielhaft rotem und blauem Licht RO, BL sowie dessen Detektion durch den jeweils anderen LED-Chip R, B gemäss der Erfindung. In der FIG 7 ist der "rote" LED-Chip R zum Aussenden rotem Licht angesteuert. Die ausgesandten roten Lichtstrahlen RO werden durch die im LED-Gehäuse 7 ausgebildete optische Linse LI fokussiert. Ein Teil der Lichtstrahlen RO wird jedoch an der Grenzfläche GF zur aussenliegenden Umgebungsluft reflektiert und gelangt als Streulicht unter anderem auch zum "blauen" LED-Chip B. Mittels dieser optischen Kopplung ist Licht vom "roten" LED-Chips R durch den "blauen" LED-Chip B detektierbar. FIG 8 zeigt analog den Fall des Aussendens von blauem Licht und der Detektion eines Teils der reflektierten blauen Lichtstrahlen BL durch den "roten" LED-Chip R.

FIG 9 zeigt eine beispielhafte Schaltungsanordnung zur wechselweisen Ansteuerung sowie zur wechselweisen Auswertung zweier LED-Chips R, B jeweils mittels eines Transimpedanzwandlers R_{TI} gemäss der Erfindung. Im unteren Teil der FIG 9 ist eine als Mikrocontroller ausgebildete Steuereinheit MC dargestellt, welche dazu programmiert ist, wechselweise die beiden Schalter SR, SB zu schliessen und zu öffnen. Die beiden Schalter SR, SB sind üblicherweise Schalttransistoren. Sie sind im vorliegenden Beispiel im Mikrocontroller MC bereits integriert. Mit den beiden Schaltern SR, SB werden die beiden LED-Chips R, B wechselweise zur Lichtaussendung an eine Versorgungsspannung VCC geschaltet. Ein jeweils parallel zu einem LED-Chip R, B geschalteter ohmscher Widerstand R_{TI} ist dazu vorgesehen, einen jeweiligen erzeugten Photostrom I_{B}, I_{R} in der Betriebsart "Photodiode" in eine entsprechende Photospannung U_{B}, U_{R} umzuwandeln. Der Ohmwert der beiden Widerstände R_{TI} ist dabei um ein Vielfaches grösser als der Innenwiderstand der LED-Chips R, B in Vorwärtsrichtung. Die nun vorliegenden Photospannungen U_{B}, U_{R} können dabei besonders einfach durch einen A/D-Umsetzer erfasst und durch den Mikrocontroller MC ausgewertet werden. Die A/D-Umsetzer können auch im Mikrocontroller MC integriert sein.

FIG 10 zeigt abschliessend ein Beispiel für eine erfindungsgemässe Rauchdetektionseinheit für einen Streulichtrauchmelder. Der Melder weist eine Zweifarben-Leuchtdiode DL und einen Photoempfänger 2 mit vorgeschalteter Linse 4 in einer Vorwärtsstreulichtanordnung auf. Mit LY ist eine optische Messkammer bezeichnet, die für zu detektierenden Rauch durchlässig und gegenüber direktem Umgebungslicht abgeschirmt ist. Erreicht wird dies durch eine geeignete Anordnung von Lamellen 6 der Messkammer LY. Mit A ist die optische Achse der Leuchtdiode DL und mit EA die optische Empfangsachse des Photoempfängers 2 bezeichnet. Beide Achsen A, EA bilden beispielhaft einen Vorwärtsstreulichtwinkel von etwa 60°. Mit Z ist ein Streulichtzentrum bezeichnet. Ein Teil des Streulichts von zu detektierenden Partikeln, die von der Leuchtdiode DL in diesem Streulichtbereich bzw. Streulichtvolumen Z beleuchtet werden, gelangen schliesslich zum Photoempfänger 2. Um zu vermeiden, dass direktes Licht von der Leuchtdiode DL zum Photoempfänger 2 gelangt, sind zusätzlich Blenden 3, 5 vorgesehen. Mit RO' und BL' sind ausgesandte Lichtbündel bezeichnet, welche die Blende 3 der Leuchtdiode DL passieren. Gemäss der Erfindung kann zwischen der Leuchtdiode DL und der Blende 3 ein Rückstreuobjekt OB oder an der Blende eine reflektierende Schicht F angebracht werden, so dass ein Teil des ausgesandten Lichtbündels RO, BL wieder in Richtung zur Leuchtdiode DL reflektiert wird. Ein Teil dieses Streulichts S gelangt dann zum jeweiligen, nicht angesteuerten LED-Chip R, B. Eine an diesem LED-Chip R, B erzeugte Photospannung kann dann über die Anschlusskontakte 1 der Leuchtdiode DL erfasst und ausgewertet werden.

### Bezugszeichenliste

- 1, 10-13: Anschlusskontakte
- 2: Photosensor, Photodiode, Silizium-PIN-Photodiode
- 3: Blende, Lochblende
- 4: Photoempfängerlinse
- 5: Photoempfänger-Blende
- 6: Lamelle, Lichtabschirmelement
- 7: Gehäuse, LED-Gehäuse, Leuchtdiodengehäuse
- 8: LED-Chipträger, Träger, Trägerplatte
- 9: Bonddrähte
- A: optische Achse, optische Sendeachse
- B: blauer LED-Chip
- BL: blaues Lichtbündel
- BL': passierendes blaues Lichtbündel
- DL: Zweifarben-Leuchtdiode, DUAL-LED
- EA: optische Achse, optische Empfangsachse
- F: reflektierende Schicht, Farbschicht
- GF: optische Grenzfläche
- I_{R}, I_{B}: Photostrom
- KL: Kantenlicht
- L: Leuchtdiode, LED
- LI: optische Linse
- LY: optische Messkammer, Labyrinth
- MC: Steuereinheit, Mikrocontroller
- OB: Rückstreuobjekt
- OK: optische Kopplung
- PD: Photosensorchip, Photodiode
- R: roter LED-Chip
- RO: rotes Lichtbündel
- RO': passierendes rotes Lichtbündel
- R_{TI}: Widerstand, Transimpedanzwandler
- S: rückgestreutes Licht
- SR, SB: ansteuerbarer Schalter, Transistor
- U_{R}, U_{B}: Photospannung
- VCC: Versorgungsspannung
- Z: Streulichtzentrum, Messvolumen

## Patentansprüche

1. Optische Rauchdetektionseinheit für einen Gefahrenmelder, insbesondere für einen Rauchmelder, welche zumindest aufweist
- eine Leuchtdiode (L) zum Aussenden von Licht, wobei die Leuchtdiode (L) eine einstückige Baueinheit ist und ein LED-Gehäuse (7) mit einem darin angeordneten LED-Chip (R, B) sowie den LED-Chip (R, B) kontaktierende, aus dem LED-Gehäuse (7) herausgeführte Anschlusskontakte (1) umfasst,
- einen zumindest spektral auf ausgesandtes Licht empfindlichen Photoempfänger (2) für die Rauchdetektion,
- eine mit der Leuchtdiode (L) und mit dem Photoempfänger (2) verbundene Steuereinheit (MC) zur elektrischen Ansteuerung der Leuchtdiode und zur Bewertung eines vom Photoempfänger (2) ausgegebenen Sensorsignals auf Brandkenngrössen hin,
**dadurch gekennzeichnet,**
- **dass** die Leuchtdiode (L) einen spektral auf das ausgesandte Licht empfindlichen Photosensor (PD) aufweist und
- **dass** die Steuereinheit (MC) dazu eingerichtet ist, während der elektrischen Ansteuerung der Leuchtdiode (L) zugleich eine elektrische Kenngrösse des Photosensors (PD) zu erfassen, um daraus eine Alterungsinformation der Leuchtdiode (L) abzuleiten und auszugeben und/oder um daraus eine Abnahme des Lichtstroms der Leuchtdiode (L) zu bestimmen und diese durch eine geänderte elektrische Ansteuerung der Leuchtdiode (L) zu korrigieren.

2. Rauchdetektionseinheit nach Anspruch 1, wobei der Photosensor (PD) eine spektral auf das ausgesandte Licht empfindliche Photodiode, insbesondere eine PIN-Photodiode ist.

3. Rauchdetektionseinheit nach Anspruch 1, wobei die Leuchtdiode (L) zwei vorzugsweise typgleiche LED-Chips (R, B) aufweist, wobei ein erster der beiden LED-Chips (R, B) zum Aussenden von einfarbigem Licht vorgesehen ist, während der andere zweite LED-Chip (R, B) zum Betrieb als Photodiode (PD) vorgesehen ist, wobei die Steuereinheit (MC) dazu eingerichtet ist, den ersten LED-Chip (R, B) elektrisch anzusteuern und zugleich den durch den zweiten LED-Chip (R, B) fliessenden Photostrom (I_{R}, I_{B}) oder eine durch den zweiten LED-Chip (R, B) erzeugte Photospannung (U_{R}, U_{B}) zu erfassen, um daraus die Alterungsinformation des ersten LED-Chips (R, B) abzuleiten und auszugeben und/oder um daraus die Abnahme des Lichtstroms des ersten LED-Chips (R, B) zu bestimmen und diese durch eine geänderte elektrische Ansteuerung des ersten LED-Chips (R, B) zu korrigieren.

4. Rauchdetektionseinheit nach Anspruch 1, wobei die Leuchtdiode (L) eine Zweifarben-Leuchtdiode (DL) ist, wobei die Zweifarben-Leuchtdiode (DL) einen ersten und zweiten LED-Chip (R, B) zum Aussenden von Licht in einem ersten und in einem davon verschiedenen zweiten Wellenlängenbereich aufweist, wobei die Steuereinheit (MC) dazu eingerichtet ist, einen der LED-Chips (R, B) elektrisch anzusteuern und den anderen LED-Chip (B, R) in eine Betriebsart als Photodiode (PD) zu schalten, und wobei die Steuereinheit (MC) dazu eingerichtet ist, den durch den anderen LED-Chip (B, R) fliessenden Photostrom (I_{R}, I_{B}) oder eine durch den anderen LED-Chip (B, R) erzeugte Photospannung (U_{R}, U_{B}) als elektrische Kenngrösse zu erfassen, um daraus die Alterungsinformation des jeweiligen angesteuerten LED-Chips (R, B) abzuleiten und auszugeben und/oder um daraus die Abnahme des Lichtstroms des jeweiligen angesteuerten LED-Chips (R, B) zu bestimmen und diese durch eine geänderte elektrische Ansteuerung des jeweiligen angesteuerten LED-Chips (R, B) zu korrigieren.

5. Rauchdetektionseinheit nach Anspruch 3 oder 4, wobei die zwei LED-Chips (R, B) nebeneinander auf einem Chipträger (8) der Leuchtdiode (D, DL) angeordnet sind, wobei eine Kante eines LED-Chips (R, B) einer Kante des anderen LED-Chips (B, R) gegenüberliegt, sodass seitlich ausgesendetes Kantenlicht (KL) eines LED-Chips (R, B) optisch seitlich in den anderen LED-Chip (B, R) einkoppelt.

6. Rauchdetektionseinheit nach Anspruch 1, wobei die Leuchtdiode (L) eine Zweifarben-Leuchtdiode (DL) ist, wobei die Zweifarben-Leuchtdiode (DL) einen ersten und zweiten LED-Chip (R, B) zum Aussenden von Licht in einem ersten und in einem davon verschiedenen zweiten Wellenlängenbereich aufweist, wobei der Photosensor (PD) eine spektral auf das ausgesendete Licht empfindliche Photodiode, insbesondere eine PIN-Photodiode ist, und wobei die Steuereinheit (MC) dazu eingerichtet ist, wahlweise einen der LED-Chips (R, B) elektrisch anzusteuern und zugleich den durch die Photodiode (PD) fliessenden Photostrom (I_{R}, I_{B}) oder eine an der Photodiode (PD) erzeugte Photospannung (U_{R}, U_{B}) als elektrische Kenngrösse zu erfassen, um daraus die Alterungsinformation des jeweiligen angesteuerten LED-Chips (R, B) abzuleiten und auszugeben und/oder um daraus die Abnahme des Lichtstroms des jeweiligen angesteuerten LED-Chips (R, B) zu bestimmen und diese durch eine geänderte elektrische Ansteuerung des jeweiligen angesteuerten LED-Chips (R, B) zu korrigieren.

7. Rauchdetektionseinheit nach einem der vorherigen Ansprüche, wobei das LED-Gehäuse (7) an seiner Aussenseite eine derartige optische Grenzfläche (GF) zur Umgebungsluft ausbildet, dass ein Teil des von einem LED-Chip (R, B) ausgesandten Lichts zum Photosensor (PD) respektive zum anderen LED-Chip (B, R) reflektiert wird.

8. Rauchdetektionseinheit nach einem der vorherigen Ansprüche, wobei das LED-Gehäuse (7) aus einem für das auszusendende Licht transparentem Kunststoff hergestellt ist und wobei das LED-Gehäuse (7) derartige optische Eigenschaften und/oder optische Strukturen aufweist, dass ein Teil des von einem LED-Chip (R, B) ausgesandten Lichts zum Photosensor (PD) respektive zum anderen LED-Chip (B, R) reflektiert wird.

9. Rauchdetektionseinheit nach einem der vorherigen Ansprüche, wobei die Rauchdetektionseinheit eine der Leuchtdiode (L, DL) optisch nachgeschaltete Blende (3) und/oder ein optisch nachgeschaltetes Rückstreuobjekt (OB) aufweist, sodass ein Teil des ausgesandten Lichts wieder in Richtung zur Leuchtdiode (L, DL) reflektiert wird, um damit den jeweiligen LED-Chip (R, B) zu beleuchten.

10. Rauchdetektionseinheit nach einem der vorherigen Ansprüche, wobei zumindest einer der LED-Chips (R, B) zum Aussenden von Licht mit einer Wellenlänge im Bereich von 665 nm bis 1000 nm und/oder zum Aussenden von Licht mit einer Wellenlänge im Bereich von 350 nm bis 500 nm ausgebildet ist.

11. Rauchdetektionseinheit nach einem der vorherigen Ansprüche, wobei die Leuchtdiode (D, DL) ein Standardkunststoffgehäuse mit einem 3 mm- oder 5 mm-Durchmesser aufweist oder wobei die Leuchtdiode (D, DL) ein SMD-Bauelement für die Oberflächenmontage auf einem Schaltungsträger ist.

12. Streulichtrauchmelder, welcher ein Meldergehäuse und eine darin aufgenommene optische Messkammer (LY) mit zumindest einer Öffnung für den möglichen Durchtritt von zu detektierendem Rauch aufweist, wobei in der Messkammer (LY) eine gegenüber Umgebungslicht abgeschirmte Rauchdetektionseinheit nach einem der vorherigen Ansprüche 1 bis 11 aufgenommen ist, wobei der Photoempfänger (2) mit zumindest einer Leuchtdiode (L, DL) in einer Vorwärts- und/oder Rückwärtsstreulichtanordnung angeordnet ist und wobei die Steuereinheit (MC) dazu eingerichtet ist, einen Brandalarm auszugeben, falls das vom Photoempfänger (2) ausgegebene Sensorsignal einen Mindeststreulichtpegel überschreitet.

13. Offener Streulichtrauchmelder, mit einer Rauchdetektionseinheit nach einem der vorherigen Ansprüche 1 bis 11, wobei die Rauchdetektionseinheit in einem Meldergehäuse des offenen Streulichtrauchmelders angeordnet ist, wobei sich ein für die Detektion von Streulicht vorgesehener Detektionsraum ausserhalb des Meldergehäuses befindet und wobei die Steuereinheit (MC) dazu eingerichtet ist, einen Brandalarm auszugeben, falls das vom Photoempfänger (2) ausgegebene Sensorsignal einen Mindeststreulichtpegel überschreitet.

14. Extinktionsrauchmelder, mit einem Meldergehäuse mit zumindest einer Öffnung für den möglichen Durchtritt von zu detektierendem Rauch sowie eine im Meldergehäuse angeordnete, gegenüber Umgebungslicht abgeschirmte Rauchdetektionseinheit nach einem der vorherigen Ansprüche 1 bis 11, wobei der Photoempfänger (2) der Leuchtdiode (L, DL) zur Detektion von direktem Licht gegenüberliegend angeordnet ist und wobei die Steuereinheit (MC) dazu eingerichtet ist, einen Brandalarm auszugeben, falls das vom Photoempfänger (2) ausgegebene Sensorsignal einen Vergleichswert für eine maximal zulässige Lichtabschwächung unterschreitet.

15. Leuchtdiode als einstückige Baueinheit, mit einem LED-Gehäuse (7), mit zumindest einem darin angeordneten LED-Chip (R, B) sowie den jeweilige LED-Chip (R, B) kontaktierende, aus dem LED-Gehäuse (7) herausgeführte Anschlusskontakte (1), **dadurch gekennzeichnet,**
- **dass** im LED-Gehäuse (7) eine zumindest spektral auf das von den jeweiligen LED-Chips (R, B) ausgesandte Licht empfindliche Photodiode (PD), insbesondere eine PIN-Photodiode, angeordnet ist, so dass zumindest ein Teil des ausgesandten Lichts durch die Photodiode (PD) detektierbar ist, und
- **dass** die Photodiode (PD) mit den herausgeführten oder mit zumindest einem weiteren Anschlusskontakt (1) kontaktiert ist sowie bestimmungsgemäss zur Lichtdetektion und nicht zum Aussenden von Licht ausgebildet ist.
